(19) Europäisches Patentamt

European Patent Office

Office européen des brevets

(11) **EP 4 614 552 A1**

(12) **EUROPEAN PATENT APPLICATION**

(43) Date of publication:
**10.09.2025 Bulletin 2025/37**

(21) Application number: 24162268.7

(22) Date of filing: **08.03.2024**

(51) International Patent Classification (IPC):
**H01L 21/50** (2006.01)   **H01L 23/04** (2006.01)
**H01L 23/10** (2006.01)

(52) Cooperative Patent Classification (CPC):
**H01L 21/50; H01L 23/04; H01L 23/10**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Infineon Technologies AG
85579 Neubiberg (DE)**

(72) Inventors:
- **TROSKA, Georg
  58730 Fröndenberg/ Ruhr (DE)**
- **STEININGER, Christian
  59494 Soest (DE)**

(74) Representative: **Westphal, Mussgnug & Partner,
Patentanwälte mbB
Werinherstraße 79
81541 München (DE)**

Remarks:
Amended claims in accordance with Rule 137(2)
EPC.

(54) **HOUSING, SEMICONDUCTOR MODULE COMPRISING A HOUSING, AND METHOD FOR ASSEMBLING A SEMICONDUCTOR MODULE**

(57)     A housing for a semiconductor module comprises a first plurality n of side elements, and a second plurality m of hinge portions, wherein n = m + 1, in an unassembled state of the housing, the side elements are arranged successively in one row and each of the hinge portions is arranged to connect two directly neighboring side elements, each of the side elements is foldable with respect to at least one other side element about a respective folding axis, and the side elements are configured to form a closed frame in an assembled state of the housing.

EP 4 614 552 A1

**Description**

TECHNICAL FIELD

The instant disclosure relates to a housing, a semiconductor module comprising a housing, and a method for assembling a semiconductor module.

BACKGROUND

Power semiconductor module arrangements often include at least one substrate arranged in a housing. A semiconductor arrangement including a plurality of controllable semiconductor elements (e.g., two IGBTs in a half-bridge configuration) or non-controllable semiconductor elements (e.g., arrangements of diodes) is arranged on each of the at least one substrate. Each substrate usually comprises a substrate layer (e.g., a ceramic layer), a first metallization layer deposited on a first side of the substrate layer and a second metallization layer deposited on a second side of the substrate layer. The controllable semiconductor elements are mounted, for example, on the first metallization layer. The second metallization layer may optionally be attached to a base plate.

The housing is usually glued to the substrate or to a base plate. One of the functions of the housing and the glue is to seal the volume inside the housing and to contain a dielectric gel (e.g., encapsulant) inside this volume. In order to sufficiently seal the volume inside of the housing, for many applications additional mechanical connection elements may be used to form a connection between the housing and the substrate or base plate in order to hold the assembly together before curing of the sealing (glue). This usually requires the presence of a base plate such that the housing can be attached to the base plate, e.g., by means of screws or rivets, thereby pressing the housing on the substrate and/or base plate. The sealing of housings in base plate less semiconductor modules is often not satisfactory.

There is a need for a housing that allows to form a satisfactory seal between the housing and a substrate even in base plate less semiconductor module arrangements, as well as for a semiconductor module comprising such a housing, and a method for assembling a semiconductor module.

SUMMARY

A housing for a semiconductor module includes a first plurality n of side elements, and a second plurality m of hinge portions, wherein n = m + 1, in an unassembled state of the housing, the side elements are arranged successively in one row and each of the hinge portions is arranged to connect two directly neighboring side elements, each of the side elements is foldable with respect to at least one other side element about a respective folding axis, and the side elements are configured to form a closed frame in an assembled state of the housing.

A semiconductor module includes a housing in its assembled shape, and a substrate, wherein the housing forms a closed frame around the substrate and exerts pressure on each of a plurality of side surfaces of the substrate along the circumference of the substrate.

A method for assembling a semiconductor module includes folding a housing around a substrate by bending the plurality of side elements about respective bending axes until the side elements form a closed frame around the substrate and exert pressure on each of a plurality of side surfaces of the substrate along the circumference of the substrate.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

BRIEF DESCRIPTION OF THE DRAWINGS

Figure 1 is a cross-sectional view of a semiconductor module without a base plate.

Figure 2 is a cross-sectional view of a semiconductor module comprising a base plate.

Figure 3 is a cross-sectional view of a semiconductor module comprising a housing according to embodiments of the disclosure.

Figure 4, including Figures 4A - 4C, schematically illustrates different views of a housing according to embodiments of the disclosure.

Figure 5 schematically illustrates a top view of the housing of Figure 4 in an assembled state.

Figure 6, including Figures 6A - 6C, schematically illustrates different views of another housing according to embodiments of the disclosure.

Figure 7, including Figures 7A - 7D, schematically illustrates steps of a method for assembling a semiconductor module comprising a housing according to embodiments of the disclosure.

Figure 8, including Figures 8A - 8C, schematically illustrates different views of a housing according to further embodiments of the disclosure.

Figure 9, including Figures 9A - 9C, schematically illustrates different views of a housing according to even further embodiments of the disclosure.

Figure 10, including Figures 10A - 10C, schematically illustrates a cross-sectional view of the housing of Figure 7 during assembly.

Figure 11, including Figures 11A and 11B, schematically illustrates a conventional molding form and an exemplary molding form for forming a housing according to embodiments of the disclosure.

Figure 12 schematically illustrates steps of a method for forming a housing according to embodiments of the disclosure.

Figure 13 schematically illustrates a cross-sectional view of a section of a housing according to even further embodiments of the disclosure.

Figure 14 schematically illustrates a cross-sectional view of a section of a housing according to even further embodiments of the disclosure.

Figure 15, including Figures 15A and 15B, schematically illustrates a cross-sectional view of a section of a housing and a top view of a section of a housing according to even further embodiments of the disclosure.

DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

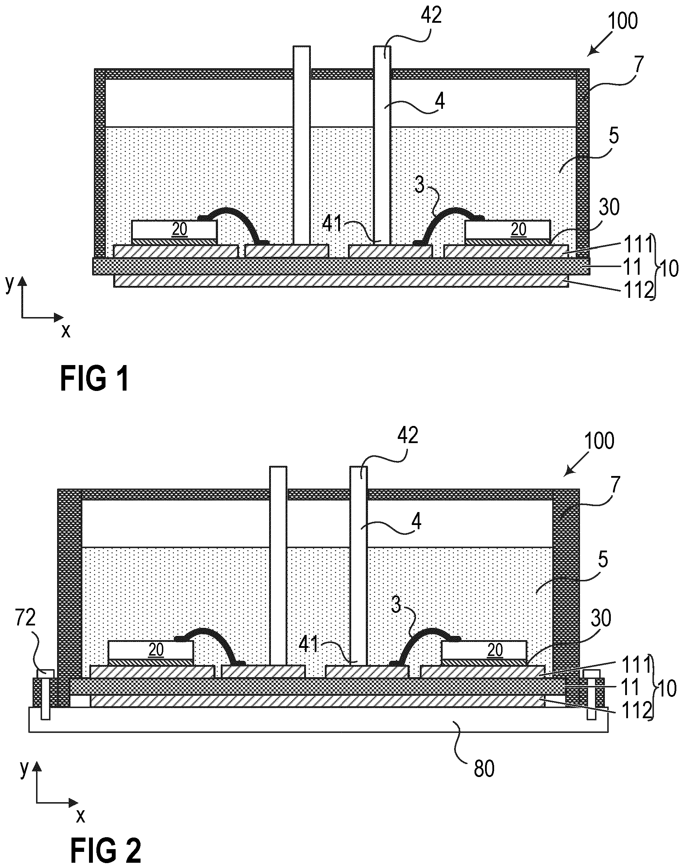

Referring to Figure 1, a cross-sectional view of a semiconductor module 100 is illustrated. The semiconductor module 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: $Al_2O_3$, AlN, SiC, BeO or $Si_3N_4$. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., $SiO_2$, $Al_2O_3$, AlN, or BN and may have a diameter of between about $1\mu m$ and about $50\mu m$. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 forms a ground surface of the housing 7, while the housing 7 itself solely comprises sidewalls and a cover. This is, however, only an example. It is also possible that the housing 7 further comprises a ground surface and the substrate 10 be arranged inside the housing 7. According to another example, the substrate 10 may be mounted on a base plate. This is schematically illustrated in Figure 2. In some semiconductor modules 100, more than one substrate 10 is arranged on a single base plate. The base plate may form a ground surface of the housing 7, for example. The top of the housing 7 can either be a separate cover or lid that can be removed from the sidewalls, or may be formed integrally with the sidewalls of the housing 7. In the latter case, the top and the sidewalls of the housing 7 may be formed as a single piece such that the top cannot be removed from the sidewalls without damaging or destroying the housing 7.

One or more semiconductor bodies 20 may be arranged on the substrate 10. Each of the semiconductor bodies 20 arranged on the substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), or any other suitable controllable or non-controllable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes four different sections. Different semiconductor bodies 20 may be mounted to the same or to different sections of the first metallization layer 111. Different sections of the first metallization layer may have no electrical connection or may be electrically connected to one or more other sections using, e.g., bonding wires 3. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer may be a solder layer, a layer of an electrically conductive adhesive, or a layer of a sintered metal powder, e.g., a sintered silver powder, for example.

The semiconductor module 100 illustrated in Figure 1 further includes terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of the terminal elements 4 protrudes out of the housing 7. The terminal elements 4 may be electrically contacted from the outside at their second end 42. The terminal elements 4 illustrated in Figure 1, however, are only examples. Terminal elements 4 may be implemented in any other way and may be arranged at any other position. For example, one or more terminal elements 4 may be arranged close to or adjacent to the sidewalls of the housing 7. Any other suitable implementation is possible. The terminal elements 4 may consist of or include a metal such as copper, aluminum, gold, silver, or any alloys thereof, for example. The terminal elements 4 may be electrically and mechanically connected to the substrate 10 by an electrically conductive connection layer (not specifically illustrated for the terminal elements 4). Such an electrically conductive connection layer generally may be a solder layer, a layer of an electrically conductive adhesive, or a layer of a sintered metal powder, e.g., a sintered silver powder, for example.

Conventional semiconductor modules 100 generally further include a casting compound 5. The casting compound 5 may consist of or include a silicone gel or may be a rigid molding compound, for example. The casting compound 5 may at least partly fill the interior of the housing 7, thereby covering the components and electrical connections that are arranged on the substrate 10. In the illustrated embodiment, terminal elements 4 may be partly embedded in the casting compound 5. At least their second ends 42, however, are not covered by the casting compound 5 and protrude from the casting compound 5 through the housing 7, to the outside of the housing 7. The casting compound 5 is configured to protect the components and electrical connections inside the semiconductor module 100, in particular inside the housing 7, from certain environmental conditions and mechanical damage.

The casting compound 5 is usually formed by filling a liquid or semi-liquid material into the housing 7. The initially liquid or semi-liquid material is then hardened (cross-linked), e.g., by heating the semiconductor module 100. The hardening or crosslinking process generally requires a certain amount of time. That is, the material remains liquid or semi-liquid for a certain amount of time and there is a risk that material leaks out of the housing 7 before it has been hardened to such a degree that it may no longer leak out of the housing 7. In arrangements similar to the one that is illustrated in Figure 1 (base plate less semiconductor modules), the housing 7 is usually glued directly on the substrate 10. The glue which attaches the housing 7 to the substrate 10 is not only required to attach the housing 7 to the substrate 10, but also to sufficiently seal the housing 7 to prevent material forming the encapsulant 5 from leaking out of the housing 7. This similarly applies for semiconductor modules 100 where the housing 7 is attached to the substrate 10 in different ways instead of gluing, as well as for semiconductor modules 100 similar to the semiconductor module 100 of Figure 2 (semiconductor modules comprising a base plate 80). Here, the housing 7 is usually attached to the base plate 80 by means of suitable mechanical connection elements, e.g., by means of rivets or screws 72. When attaching the housing 7 to the base plate 80, the housing 7, at the same time, may be pressed on the base plate 80 and/or the substrate 10. A sealing may be provided between the housing and the base plate 80 and/or between the housing 7 and the substrate 10 in order to prevent material forming the encapsulant 5 from leaking out of the housing 7. The arrangements as illustrated in Figures 1 and 2 may be sophisticated and complex and mounting the housing 7 to the substrate 10 or base plate 80 may be cumbersome. Further, production costs of the housing 7 may be comparably high.

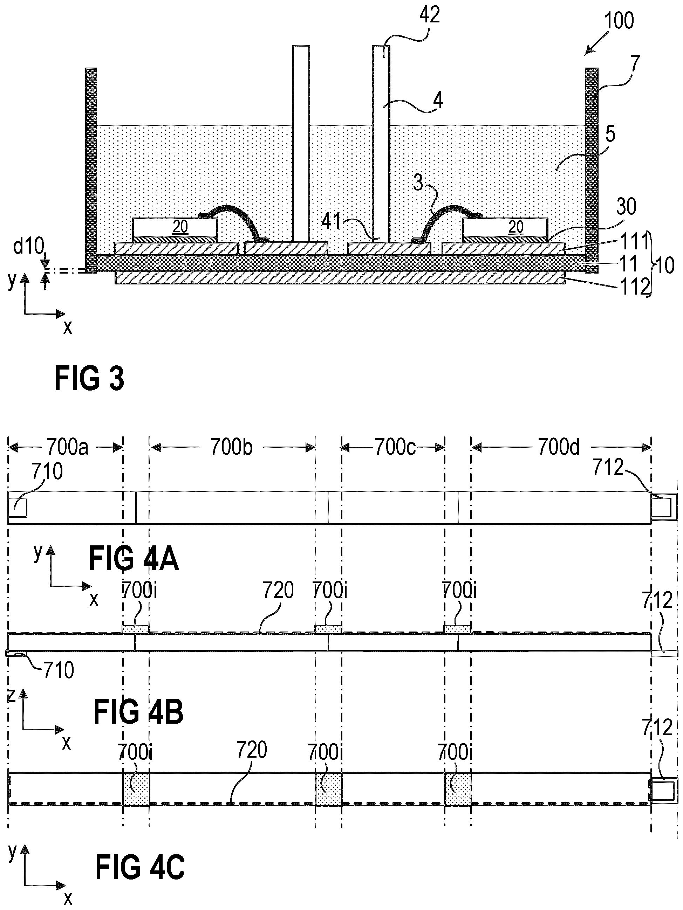

Now referring to Figure 3, a semiconductor module 100 according to embodiments of the disclosure is schematically illustrated. The semiconductor module 100 may be a base plate less module, for example. That is, the substrate 10 itself may form a base surface of the housing 7. The housing 7, however, instead of being glued to the substrate 10 or attached to the substrate 10 by any kind of mechanical connection means, is instead simply folded around the substrate 10. That is, the housing 7 is in contact with the side surfaces of the substrate 10, wherein the side surfaces are surfaces of the substrate 10 extending between a top surface of the substrate 10 and a bottom surface of the substrate 10, opposite the top surface. The top surface of the substrate 10 is a surface on which the semiconductor bodies 20 are mounted and which faces the inside of the housing 7, when the housing 7 is mounted to the substrate 10. The housing 7 may apply a certain amount of pressure on the side surfaces of the substrate 10 in order to securely hold the substrate 10 in a desired position with respect to the housing 7. This will be described further by means of Figures 4 to 7 in the following. However, it is also contemplated that some kind of glue or sealing may be applied between the inside of the housing 7 and the side surfaces of the substrate 10, to more effectively seal the interior and/or to more securely fix the housing 7 to the substrate 10.

Figures 4A to 4C illustrate a housing 7 according to embodiments of the disclosure in an unmounted (unfolded state), wherein Figure 4A illustrates an outside of the housing 7, Figure 4B illustrates a top view of the housing 7, and Figure 4C illustrates an inside of the housing 7. The housing 7 comprises a first plurality n of side elements 700n, a second plurality m of hinge portions 700i, and a fastening element 710, 712. The number of hinge portions 700i may be one less than the number of side elements 700n. That is, n = m + 1. In an unassembled state of the housing 7, the side elements 700n are arranged successively in one row and each of the second plurality m of hinge portions 700i is arranged to connect two directly neighboring side elements 700n to each other. Each of the first plurality n of side elements 700n is foldable with respect to at least one other side element 700n about a respective folding axis.

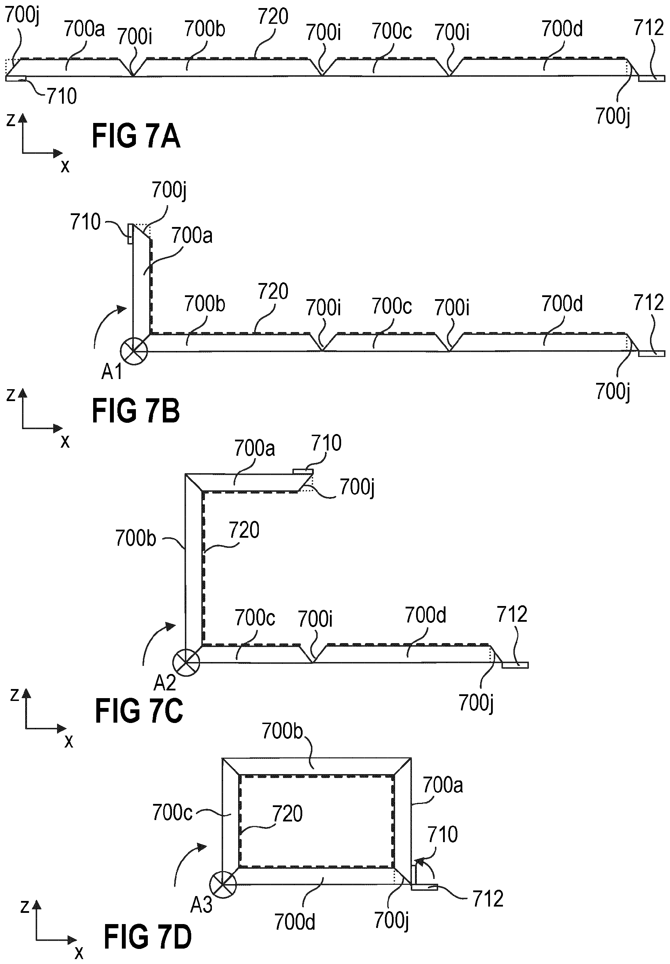

For example, a first outermost side element 700a in the row of side elements 700n (the first outermost side element 700a only has one neighboring side element 700b) may be foldable about a first folding axis. In particular, the first outermost side element 700a may be foldable with respect to a directly preceding second side element 700b. The respective folding axis may be located at a position between the first outermost side element 700a and the second side element 700b (see, e.g., first folding axis A1 in Figure 7B). The second side element 700b, being arranged between two other side elements 700a, 700c, may be foldable with respect to each of its neighboring side elements 700a, 700c about respective folding axes (see, e.g., first folding axis A1 and second folding axis A2 in Figures 7B and 7C). This similarly applies for the third side element 700c which is foldable with respect to each of its neighboring side elements 700b, 700d about respective folding axes (see, e.g., second folding axis A2 and third folding axis A3 in Figures 7C and 7D). In the examples described herein, the fourth side element 700d is another outermost side element at an opposite end of the row of side elements 700n than the first outermost side element 700a. The fourth outermost side element 700d, similar to the first outermost side element 700a, is foldable only with respect to one other side element, namely the third side element 700c (see, e.g., third folding axis A3 in Figure 7D).

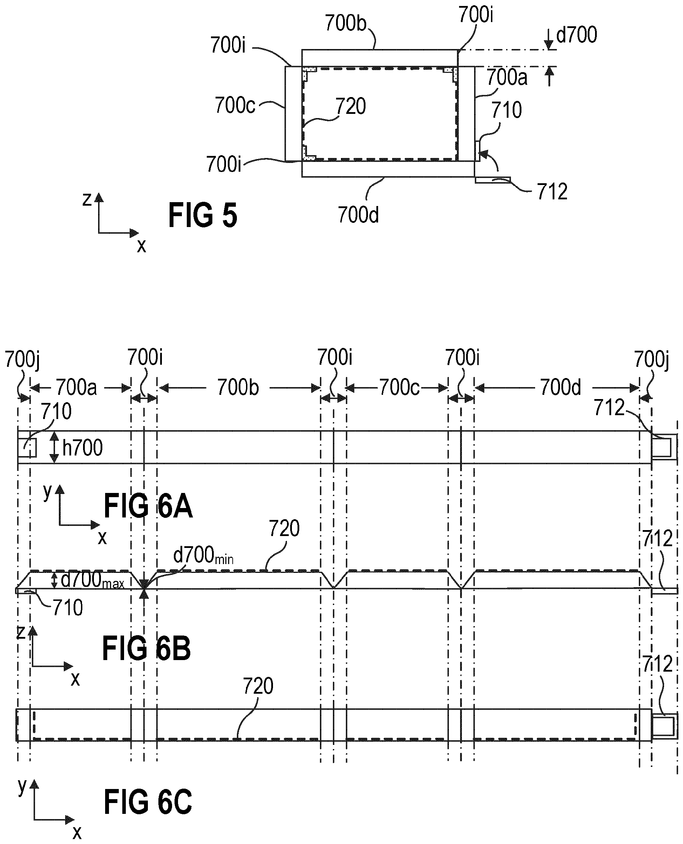

As can be seen in Figures 5 and 7D, for example, the first plurality n of side elements 700n is configured to form a closed frame in an assembled state. The fastening element 710, 712 is configured to connect the two outermost side elements 700a, 700d with each other such that the housing 7 remains in its assembled / folded shape and exerts pressure on a substrate 10 arranged within the closed frame formed by the side elements 700n. According to one example, the two outermost side elements 700a, 700d, in an assembled state of the housing 7, may be simply glued or welded to each other. That is, the fastening element may comprise a glue bead or welding seam, for example. According to another example, the fastening element 710, 712 may be any kind of snap-fit connector or latching mechanism. In the examples illustrated in Figures 4 to 9, the fastening element 710, 712 comprises a protrusion 710 arranged on the outside (in the assembled state) of the first outermost side element 700a, and a kind of loop 712 attached to the fourth outermost side element 700d. When the housing 7 has been folded to form a closed loop, the loop 712 may be folded to engage with the protrusion 710. In this way, the two outermost side elements 700a, 700d may be securely attached to each other such that the housing 7 remains in its folded state. That is, the two outermost side elements 700a, 700d may be permanently attached to each other (e.g., by gluing or welding) such that they may not be easily separated again, or the two outermost side elements 700a, 700d can be separated again by simply opening the fastening element 710, 712. The latter is generally possible with many latching mechanisms which can be released again by applying a certain amount of force without damaging the fastening element 710, 712 or the two outermost side elements 700a, 700d in any way.

In the embodiments described herein, the housing 7 in its folded state has a rectangular shape. This, however, is only an example. It is also possible that the housing 7 in its folded state has a square shape. That is, according to embodiments of the disclosure, n may be 4 and m may be 3 (n = 4, m = 3). It is, however, possible that the housing 7 comprises more (e.g., more than four) or less (e.g., three) side elements 700n. That is, the housing 7 in its folded state generally may have any polygonal shape. As there are always two free ends (two outermost side elements), the number m of hinge portions 700i is always one less than the number n of side elements 700n.

The hinge portions 700i may be implemented in many different ways. In the example illustrated in Figure 4, the hinge portions 700i each comprise a continuous section of a flexible material. For example, the side elements 700n may be formed by a comparably rigid (e.g., plastic) material in order to provide sufficient stability for the housing 7. The side elements 700n may further have a certain thickness d700, e.g., between 1 mm and 3 mm. The side elements 700n, therefore, may not be easily bent without causing damage to the side elements 700n. The hinge portions 700i may be formed by applying a comparably flexible material to the edges of the respective side elements 700n facing each other. The hinge portions 700i, therefore, are flexible to a certain degree. In this way, they can be bent in order to form the closed frame. On the other hand, the flexible portions 700i are still able to form a permanent connection between the respective ones of the side elements 700n.

Another example of how the hinge portions 700i can be implemented is schematically illustrated in Figure 6, wherein Figure 6A illustrates an outside of the housing 7, Figure 6B illustrates a top view of the housing 7, and Figure 6C illustrates an inside of the housing 7. Each of the side elements 700n has the first thickness $d700_{max}$, and each of the hinge portions 700i comprises a first end having the first thickness $d700_{max}$ and connected to one of the side elements 700n, and a second end having the first thickness $d700_{max}$ and connected to another one of the side elements 700n. Each hinge portion 700i further comprises a first section, a second section, and a third section arranged successively between the first end and the second end, wherein the second section has a second thickness $d700_{min}$ that is less than the first thickness $d700_{max}$. A thickness of the first section between the first end and the second section gradually decreases from the first thickness $d700_{max}$ to the second thickness $d700_{min}$, and a thickness of the third section between the second section and the second end gradually increases from the second thickness $d700_{min}$ to the first thickness $d700_{max}$. The housing 7 is configured to form a closed frame in an assembled shape by bending the second sections of the connecting portions 700i about a respective folding axis until the respective first and third sections are in direct contact with each other. The hinge portions 700i in this example may be formed of the same material as the side elements 700n. That is, the hinge portions 700i may also be made from a comparably rigid (e.g., plastic) material. As the thickness of the hinge portions 700i is reduced to the second thickness $d700_{min}$ in their respective second sections, they may, however, still be bendable. That is, the second sections of the hinge portions 700i may be thin enough in order to allow them to be bent sufficiently to form the closed loop. The second sections of the hinge portions 700i remain intact also in the assembled state of the housing in order to couple the respective side elements 700n to each other.

A folding process of the housing of Figure 6 is schematically illustrated in Figures 7A to 7D, wherein Figure 7A illustrates the housing in its unfolded state, Figure 7D illustrates the housing in its assembled state, and Figures 7B and 7C illustrate intermediate steps between the unfolded and the assembled state. In Figures 7A to 7D, a substrate 10 is not specifically illustrated. The housing 7, however, may be easily folded around a substrate 10, resulting in an arrangement similar to what is illustrated in Figure 3. The shape of the housing 7 in its folded state (inner circumference) corresponds to the shape of the respective substrate (outer circumference). In this way, each side surface of the substrate 10 will be contacted by a respective one of the side elements 700n of the housing 7.

In the example illustrated in Figure 4, the side elements 700n are essentially rectangular and two neighboring side elements 700n directly contact each other. This results in a somewhat irregular shape of the housing 7 in the assembled state (see, e.g., Figure 5). The hinge portions 700i as illustrated in Figure 6 result in a more regular shape of the housing 7 in the assembled state. In the example of Figures 4 and 5, the fourth outermost side element 700d in the assembled state rests flat on the first outermost side element 700a. This, however, is only an example. The housing 7 may further comprise a first connecting section 700j, and a second connecting section 700j. The first and second connecting section 700j may each form an outermost end of the housing 7 in its unfolded state. This is schematically illustrated in Figures 6A to 6C and 7A to 7D. The first connecting section 700j may comprise a first end having the first thickness $d700_{max}$ and being connected to the first outermost side element 700a such that the first outermost side element 700a is arranged between the first connecting section 700j and the respective hinge portion 700i connected to an opposite end of the first outermost side element 700a. The thickness of the first connecting portion 700j gradually decreases towards a second end of the first connecting portion 700j facing away from the first outermost side element 700a. The first connecting portion 700j, for example, may have a triangular cross-section. The same applies for the second connecting portion 700j, which may comprise a first end having the first thickness $d700_{max}$ and being connected to the fourth outermost side element 700d such that the fourth outermost side element 700d is arranged between the second connecting section 700j and the respective hinge portion 700i connected to an opposite end of the fourth outermost side element 700d. The thickness of the second connecting portion 700j gradually decreases towards a second end of the second connecting portion 700j facing away from the fourth outermost side element 700d. The second connecting portion 700j, for example, may have a triangular cross-section. In the assembled state of the housing 7, the first connecting portion 700j and the second connecting portion 700j may be in direct contact with each other, forming one of the corners of the housing 7 (see, e.g., Figure 7D).

The housing 7, i.e. the side elements 700n, may have a height h700 in a vertical direction y. When the housing 7 is folded around a substrate 10, the substrate 10 may contact the side elements 700n in an area towards a lower end of the side elements 700n. A lower end of the side elements 700n is an end opposite a top end to which a cover or lid may be mounted. For example, a distance d10 (see Figure 3) between the substrate 10 and the lower end in the vertical direction y may be between 0 and 2cm. In this way, the substrate 10 forms the bottom of the housing 7. When the housing 7 is folded around the substrate 10 and the two outermost side elements 700a, 700d (and the first and second connecting portions 700j, respectively) have been securely attached to each other by means of the fastening element 710, 712, a force is applied to the substrate 10 horizontally from all sides. In this way, the substrate 10 is clamped by the closed frame formed by the side elements 700n. The substrate 10 may be in direct contact with the side element elements 700n of the housing. However, there is a risk that the housing 7 is not entirely sealed.

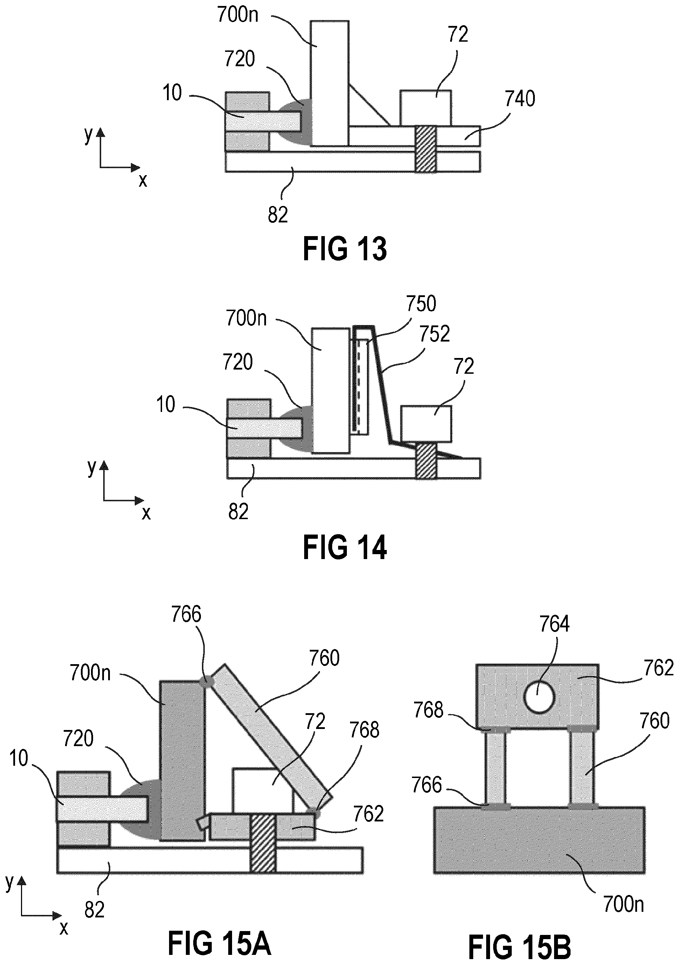

Therefore, the housing 7 may further comprise a sealing element 720. The sealing element 720, in the assembled state of the housing 7, extends around the inner volume defined by the first plurality n of side elements 700n. A sealing element 720 is exemplarily illustrated in Figures 4 to 7 by means of a dashed line. As can be seen in Figures 4B, 4C, 6B and 6C, for example, the sealing element 720 may be discontinuous in the unassembled state of the housing 7. In particular, the sealing element 720 may be interrupted in the areas of the hinge portions 700i. That is, the sealing element 720 is attached to the side elements 700n, but not to the hinge portions 700i. The sealing element 720 may form a continuous loop along the inner circumference of the housing 7 in the assembled state, as is illustrated in Figures 5 and 7D, for example. The sealing element 720 is configured to be arranged between the substrate 10 and the side elements 700n in the assembled state. According to one example, the sealing element 720 is formed by a comparably soft material (e.g., silicone material, or silicone rubber material). For example, the sealing element 720 may be a bead or bulge extending along the side elements 700n in an area towards the lower end of the side elements 700n, e.g., within 0 and 1cm, or between 0 and 2cm, from a lower end of the side elements 700n. When the housing 7 is arranged to surround the substrate 10, and the sealing element 720 is arranged between the substrate 10 and the side elements 700n, the sealing element 720 is deformed to a certain degree due to the pressure that is applied by the housing 7. That is, the substrate 10 presses into the sealing element 720 to a certain degree. In this way, the connection between the side elements 700n and the substrate 10 is even tighter, resulting in a very reliable mechanical fixation of the substrate 10 with respect to the housing 7. Further, the sealing element 720 may reliably prevent material from leaking out of the housing 7, e.g., when a liquid or viscous material is filled into the housing 7 in order to form an encapsulant 5. This is schematically illustrated in Figures 13, 14 and 15A, for example, where the substrate 10 presses into the sealing element 720 arranged between the substrate 10 and the side elements 700n.

Referring to Figures 4C and 6C, for example, sections of the sealing element 720 may also extend in a vertical direction y of the side elements 700n. In particular, one section of the sealing element 720 extending in the vertical direction y may be arranged on the first outermost side element 700a, and/or one section of the sealing element 720 extending in the vertical direction y may be arranged on the fourth outermost side element 700d. In this way, the housing 7 may be sealed also in a section where the first outermost side element 700a and the fourth outermost side element 700d are in direct contact with each other. That is, a vertical section of the sealing element 720 may extend along an end of the first outermost side element 700a that faces away from the end connected to the respective hinge portion 700i. Similarly, a vertical section of the sealing element 720 may extend along an end of the fourth outermost side element 700d that faces away from the end connected to the respective hinge portion 700i. In the assembled state of the housing 7, the vertical sections of the sealing element 720 may be in direct contact with each other, thereby sealing the connection point between the two outermost side surfaces 700a, 700d.

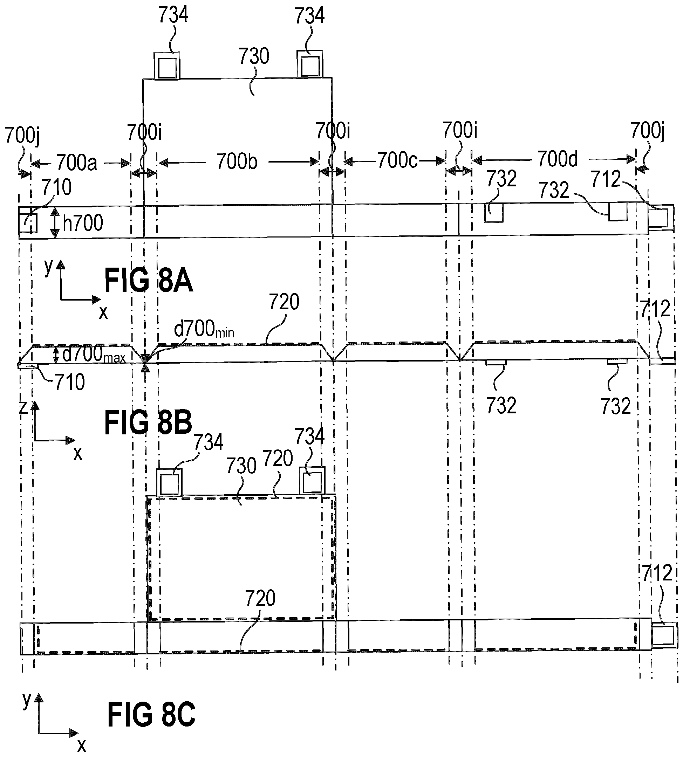

In the examples illustrated in Figures 4 to 7, the housing 7 comprises only sidewalls (side elements 700n). A separate lid or cover may be arranged on the sidewalls to close the housing 7 after the housing 7 has been folded around the substrate 10, for example. According to another example, the housing 7 may comprise a lid 730 that is coupled to (or integrally formed with) one of the plurality of side elements. In the example illustrated in Figures 8A to 8C, a lid 730 is coupled to a second one of the side elements 700b. Figure 8A illustrates an outside of the housing 7, Figure 8B illustrates a top view of the housing 7, and Figure 8C illustrates an inside of the housing 7. The lid 730 is foldable with respect to an additional folding axis. In the assembled state of the housing 7, the closed frame formed by the first plurality n of side elements 700n defines an inner volume. The lid 730, which in an unassembled state of the housing 7 is arranged in the same plane as the plurality of side elements 700n, may be bent about a folding axis with respect to the respective side element 700b such that, in the assembled state of the housing 7, it covers the inner volume from one side (i.e. from a top side opposite the lower side to which the substrate 10 is attached). In the assembled state, the lid 730 is arranged perpendicular to each of the plurality of side elements 700n. The lid 730 may be attached to the respective side element 700n in any suitable way which allows it to be bent about the respective folding axis. The lid 730, for example, may be attached to the respective side element 700n by means of a suitable hinge element, which allows a bending of the lid 730 with respect to the side elements 700n. In the assembled state of the housing 7, the lid 730 may be securely attached to the side elements 700n by means of suitable fastening elements 732, 734, similar to what has been described with respect to the two outermost side elements 700a, 700d and the respective fastening element 710, 712 above. That is, the fastening elements 732, 734 that attaches the lid 730 to the side elements 700n may comprise any kind of snap-fit connectors, for example.

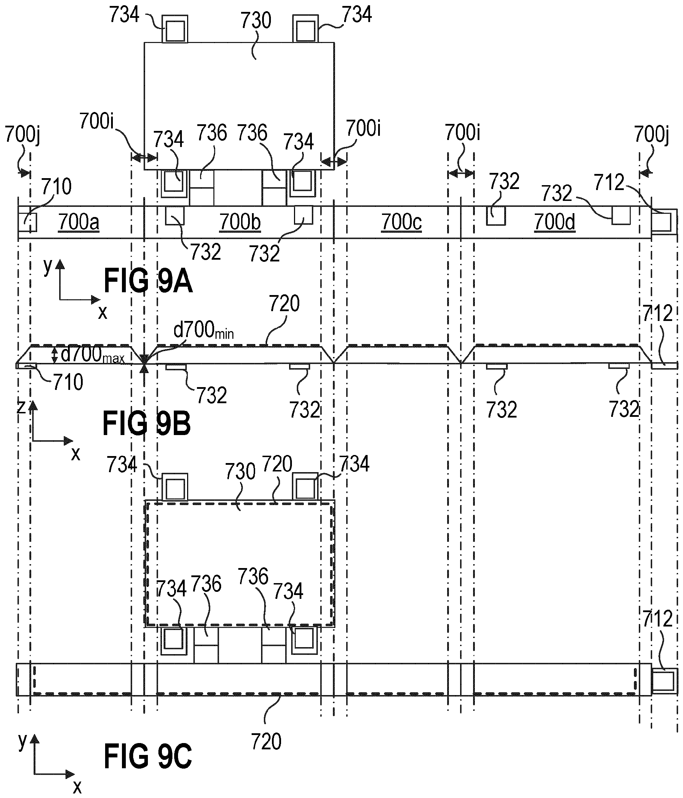

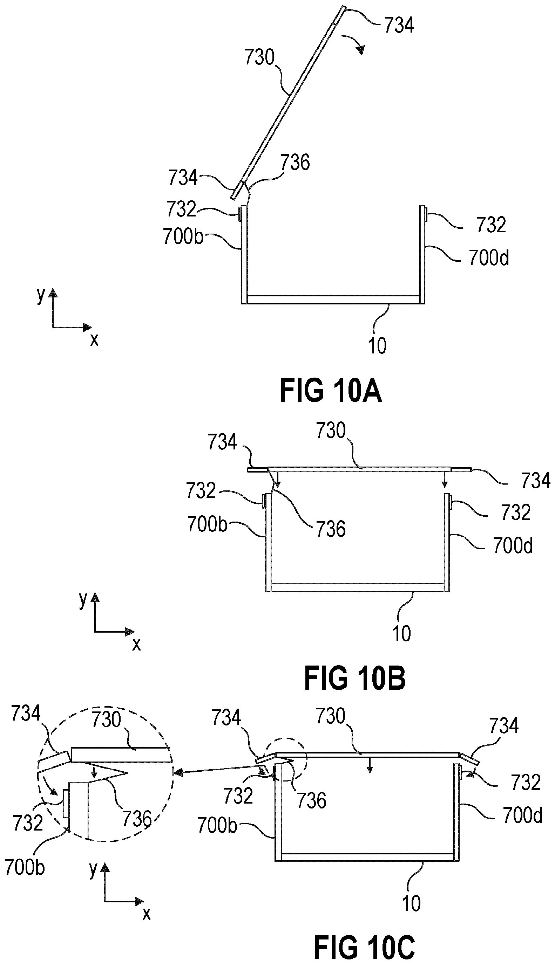

Now referring to Figure 9, the lid 730 may be coupled to the respective one of the plurality of side elements 700b by means of a foldable element 736. Figure 9A illustrates an outside of the housing 7, Figure 9B illustrates a top view of the housing 7, and Figure 9C illustrates an inside of the housing 7. The foldable element 736 may be configured to be folded in an accordion-like way, which is schematically illustrated in Figure 10 which illustrates a cross-sectional view of a housing 7 folded around a substrate 10. The foldable element 736, for example, may comprise two sections. A first section may be coupled to the respective side element 700b, and a second section may be coupled to the lid 730. The first section may be bendable with respect to the side element 700b, the second section may be bendable with respect to the lid 730, and the first and second section may be bendable with respect to each other. This allows a movement of the lid 730 that is linearly downward, instead of a rotary motion (as in the example of Figure 8). As has been described with respect to Figure 1 above, a semiconductor module generally comprises terminal elements 4 extending vertically through the housing 7. The lid 730 may comprise openings (not specifically illustrated in Figures 9A and 9C through which the terminal elements 4 may extend towards the outside of the housing 7. Such terminal elements 4 are generally already arranged on the substrate 10 when the lid 730 is closed. A rotary movement of the lid 730 may potentially cause problems when inserting the terminal elements 4 through the respective openings in the lid 730. Such problems may be avoided in the arrangement of Figure 9, due to the linearly downward movement of the lid 730, as schematically illustrated by means of the arrows in Figure 10. Figure 10A schematically illustrates the housing 7 with the lid 730 almost completely open, and Figure 10B schematically illustrates the housing 7 with the lid 730 folded to a suitable horizontal position, from which it may then be moved linearly downward in a vertical direction y toward the side elements. Figure 10C schematically illustrates the housing 7 and the lid 730 in a state shortly before the lid 730 reaches its final mounting position on the side elements. The foldable element 736 in Figure 10C is almost completely folded. A section of the housing 7 is shown in an enlarged view in Figure 10C, in order to more clearly illustrate the foldable element 736 during the folding process. The foldable element 736 as illustrated in Figures 9 and 10, however, is only an example. A linearly downward movement of the lid 730 towards the side elements 700n may also achieved in other ways.

Similar to what has been described with respect to the side elements 700n above, a sealing element 720 may also be attached to the lid 730, for example. As can be seen in Figure 9C, for example, which illustrates an inside of the housing 7, the sealing element 720 may form a continuous thread around the circumference of the lid 730 on the inside of the housing 7. When the lid 730 is closed to cover the opening defined by the side elements 700n of the housing 7, the sealing element 720 is arranged between the lid 730 and the side elements 700n, and seals any gaps between the lid 730 and the side elements 700n. Instead of on the lid 730, the sealing element 720 may also be arranged on a top surface of the side elements 700n. A sealing element 720 arranged on a top surface of the side elements 700n would be visible in the top view of Figure 9B instead of in Figure 9C. In the latter case, however, the sealing element 720 would comprise several separate sections which, in the folded state of the housing 7 would form a continuous thread around the circumference of the housing 7. When forming the sealing element 720 on the lid 730, the thread formed by the sealing element 720 would have no disruptions at all which may provide even better sealing properties.

Further sealing elements may be provided for any gaps or holes that may be present in the assembled state of the housing 7. As has been described above, a lid 730 for a housing 7 may comprise a plurality of holes through which the terminal elements 4 may protrude to the outside of the housing 7. Further sealing elements may be provided for some or all of such openings in the lid 730. According to one example, a layer of a comparably soft and flexible material may cover each of a plurality of openings in the lid 730. When a terminal element 4 is driven through an opening, it may penetrate through this layer. In the assembled state, such a sealing element then tightly surrounds the respective terminal element 4, thereby sealing the opening with the terminal element extending therethrough. Any openings through which no terminal element 4 is inserted remain covered by the respective layer of sealing material. In this way, the inside of the housing 7 may be entirely sealed to prevent any noxious gases (e.g., hydrogen or hydrogen sulphide) or contaminants from entering the inside of the housing 7.

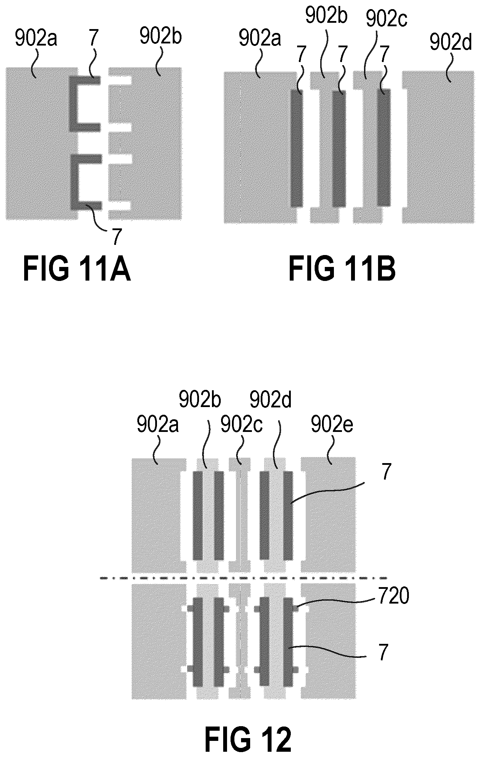

The housing 7 may be manufactured by means of an injection molding process, for example, by filling the material in a liquid or viscous form into a respective mold before hardening it. Conventional housings are often manufactured by means of injection molding processes. Conventional housings, however, are injection molded in their final form, as is schematically illustrated in the cross-sectional view of Figure 11A. As can be seen, each element 902a, 902b of the mold requires a significant amount of space, as the housings have comparably large dimensions in both horizontal directions x, z (dimensions of the lid), as well as in the vertical direction y (height of sidewalls). Now referring to Figure 11B, it can be seen that the dimensions of the housings 7 according to embodiments of the disclosure in their unassembled state significantly differ from the dimensions of conventional housings. In particular, the housings 7 in their unassembled state are comparably flat. This allows to manufacture several different housings 7 in parallel, by stacking respective molds onto each other. In the example illustrated in Figure 11B, three housings 7 are formed simultaneously with the same equipment. This, however, is only an example. It is generally possible to easily form less than three or even more than three housings 7 simultaneously with the same equipment, without requiring unusually large equipment. The molding form that is used to form the housings 7 may be a so-called multi-cavity injection molding form, comprising a plurality of different elements 902a, 902b, 902c, 902d stacked onto each other.

Typically, a simple injection molding form consists of two elements 902a, 902b which, during the molding process, are pressed to each other. A cavity defined by the two elements 902a, 902b is a negative of the housing 7 to be formed. This cavity is filled with material which is subsequently hardened before disengaging the two elements 902a, 902b from each other (see Figure 11A). In order to reduce production costs, a plurality of housings 7 may be formed in parallel by using multi-cavity forms. A size of the molding forms, however, is typically limited to a maximum of about 350mm * 350mm; larger dimensions are possible but expensive. Therefore, the ability to create higher level multi-cavity forms may be limited. Using flat geometries, as is exemplarily illustrated in Figure 11B, offers the opportunity to create multi cavity forms that are arranged serially with respect to each other. With a very flat geometry of the injection molding element (the housing 7), multi-cavity forms can be created by means of a serial multi-cavity injection molding form.

The injection molding process may be a so-called 2K LSR (liquid silicone rubber) process. This is a process where a first material is first filled into the mold and subsequently hardened, thereby forming a first injection molding component. The first injection molding component may be comparably rigid and hard after hardening, for example. For example, the side elements 700n, hinge portions 700i, fastening elements 710, 712, a lid 730, foldable element 736, as well as the first connecting section 700j and the second connecting section 700j may be formed during this first step. A second molding step follows during which one or more second injection molding components are formed. The second injection molding component may be the one or more sealing elements 720, for example. The one or more second injection molding components may be formed by injecting a different material (e.g., a liquid silicone rubber) into the mold such that the one or more second injection molding components are formed directly on the first injection molding component (first material). The second injection molding components, after curing and hardening, adhere to the first injection molding component. This may be achieved by means of rotatable forms 902a, 902b, 902c, 902d, as schematically illustrated in Figure 12.

In the top part of Figure 12, the molding form is illustrated in a first position. The first injection molding component may be formed when the different parts 902a, 902b, 902c, 902d are pressed to each other in this first position. In the example illustrated in Figure 12, four housings 7 are formed simultaneously with the same equipment. One or more of the mold parts 902a, 902b, 902c, 902d may then be rotated. In Figure 12, the two outermost mold parts 902a, 902d are rotated. When the mold parts 902a, 902b, 902c, 902d are in a second position with respect to each other (Figure 12 bottom part), the one or more second injection molding components may be formed, similar to what has been described above. A rotating axis about which the parts 902a, 902d are rotated is illustrated in dot-dashed lines in Figure 12.

Now referring to Figure 13, it is even possible to form more sophisticated foldable housings. The housing 7 as illustrated in Figure 13, for example, further comprises a mounting element 740 which allows to securely mount the housing 7 on a heat sink 82, for example. Such a mounting element 740 may comprise a protrusion with a through hole therethrough that allows a screw 72 to be inserted. Figure 13 illustrates a very simple L-shape design of a mounting element 740 with respect to the respective side element 700n. That is, the mounting element 740 may be static with respect to the side element 700n. This, however, increases the dimensions of the housing 7 in its unfolded state to a certain degree.

Figure 14 schematically illustrates another static element which can be used to mount the housing 7 onto a heat sink 82, for example. In this example, a simple, comparably flat protrusion 750 is formed along the side element 700n. The protrusion 750 may have a hole through which a first end of a spring element 752 (e.g., metal spring element) may be inserted. A second end of the spring element 752 may be attached to a heat sink 82 by means of a screw 72, for example. The first end of the spring element 752 may be inserted into the protrusion 750 from a top side (facing towards the lid of the housing 7). In this way the spring element 752 presses the housing 7 towards the heat sink 82 when the screw 72 is securely fastened.

Now referring to Figure 15, it is also possible to form foldable mounting elements. The folding mechanisms may generally resemble the folding mechanisms that have been described with respect to the hinge portions 700i and the lid 730 above. For example, a foldable mounting mechanism may comprise several different parts. A first part 760 may be attached to a side element 700n. In the example of Figure 15, the first part 760 is attached to the side element 700n by means of a silicone rubber material 766. This may be the same material that is used to form the sealing element 720, for example, and may be formed during the same production step. A second part 762 may be foldably attached to the first part 760. For example, the second part 762 may also be attached to the first part 760 by means of a silicone rubber material 768. In the unassembled state, the housing 7 with the foldable mounting element is still flat, as can be seen in Figure 15B which exemplarily illustrates a section of an outside of the housing 7 (similar to Figures 4A, 6A, 8A and 9A, for example). A cross-sectional view of a section of a housing 7 in its assembled state is schematically illustrated in Figure 15A.

As can be seen, the side element 700n, the first part 760, and the second part 762, in the assembled state, may form a triangle. The second part 762 may comprise a through hole through which a screw 72 may be inserted in order to securely attach the housing 7 to a heat sink 82. In order to allow the screw 72 to be inserted into the through hole in the assembled state, the first part 760 may also comprise an opening, a plurality of arms or may be formed by two separate sections (as schematically illustrated in Figure 15B), in order to not cover the second part 762 and the through hole. The second part 762, in the assembled state of the housing 7, may be inserted (e.g., hooked) into a respective notch or groove in the side element 700n. This makes the triangle formed by the different parts 760, 762 of the mounting element and the side element 700n very stable. Further, the force that is applied to the second part 762 when the screw 72 is fastened, is transferred to the entire side element 700n. The different mounting elements as have been described with respect to Figures 13 to 15 above, are only examples. Mounting elements may generally be implemented as static mounting elements or foldable mounting elements in any suitable way.

**Claims**

1. A housing (7) for a semiconductor module (100) comprises:

a first plurality (n) of side elements (700n); and
a second plurality (m) of hinge portions (700i), wherein

$$n = m + 1,$$

in an unassembled state of the housing (7), the side elements (700n) are arranged successively in one row and each of the hinge portions (700i) is arranged to connect two directly neighboring side elements (700n), each of the side elements (700n) is foldable with respect to at least one other side element (700n) about a respective folding axis (A1, A2, A3), the side elements (700n) are configured to form a closed frame in an assembled state of the housing (7).

2. The housing (7) of claim 1, wherein each of the hinge portions (700i) is formed by means of a silicone rubber material.

3. The housing (7) of claim 1, wherein

each of the side elements (700n) has a first thickness ($d700_{max}$),
each of the hinge portions (700i) comprises a first end having the first thickness ($d700_{max}$) and connected to one of the side elements (700n), a second end having the first thickness ($d700_{max}$) and connected to another one of the side elements (700n), a first section, a second section, and a third section arranged successively between the first end and the second end, wherein the second section has a second thickness ($d700_{min}$) that is less than the first thickness ($d700_{max}$), wherein a thickness of the first section between the first end and the second section gradually decreases from the first thickness ($d700_{max}$) to the second thickness ($d700_{min}$), and wherein a thickness of the third section between the second section and the second end gradually increases from the second thickness ($d700_{min}$) to the first thickness ($d700_{max}$), and
the housing (7) is configured to form a closed frame in an assembled shape by bending the second sections of the connecting portions (700i) about a respective folding axis (A1, A2, A3) until the respective first and third sections are in direct contact with each other.

4. The housing (7) of any of claims 1 to 3, further comprising a lid (730) coupled to one of the plurality of side elements (700b), and foldable with respect to an additional folding axis.

5. The housing (7) of claim 4, wherein, in the assembled state of the housing (7), the closed frame formed by the first plurality (n) of side elements (700n) defines an inner volume, and the lid (730) covers the inner volume from one side.

6. The housing (7) of claim 4 or 5, wherein the lid (730) is coupled to the respective one of the plurality of side elements (700b) by means of a foldable element (736), wherein the foldable element (736) is configured to be folded in an accordion-like way.

7. The housing (7) of any of claims 4 to 6, wherein, in the assembled state of the housing (7), the lid (730) is attached to the closed frame formed by the side elements (700n) by means of one or more fastening elements (732, 734).

8. The housing (7) of any of the preceding claims, further comprising a sealing element (720), wherein the sealing element (720), in the assembled state of the housing (7), extends around the inner volume defined by the side elements (700n).

9. The housing (7) of claim 8, wherein the sealing element (720) further comprises a portion forming a continuous thread around the circumference of the lid (730) such that, in the assembled state of the housing (7), it is arranged between the lid (730) and the side elements (700n), thereby sealing the inner volume of the housing (7).

10. The housing (7) of any of the preceding claims, further comprising a fastening element (710, 712), wherein the fastening element (710, 712), in the assembled state of the housing (7), is configured to connect two outermost side elements (700n) in the row of side elements (700n) with each other such that the housing (7) remains in its assembled shape.

11. The housing (7) of claim 10, wherein the fastening element (710, 712) is a snap-fit connector or latching mechanism.

12. The housing (7) of any of the preceding claims, further comprising at least one foldable mounting element attached to a side element (700n), wherein the foldable mounting element comprises a through hole for mounting the housing (7) on a heat sink (82) by means of a screw (72).

13. The housing of any of the preceding claims, wherein n = 4 and m = 3.

14. A semiconductor module (100) comprises:

a housing (7) according to any of claims 1 to 13 in its assembled shape; and
a substrate (10), wherein

the housing (7) forms a closed frame around the substrate (10) and exerts pressure on each of a plurality of side surfaces of the substrate (10) along the circumference of the substrate (10).

15. A method for assembling a semiconductor module (100), the method comprising:
folding a housing (7) according to any of claims 1 to 13 around a substrate (10) by bending the plurality of side elements (700n) about respective bending axes (A1, A2, A3) until the side elements (700n) form a closed frame around the substrate (10) and exert pressure on each of a plurality of side surfaces of the substrate (10) along the circumference of the sub-

strate (10).

**Amended claims in accordance with Rule 137(2) EPC.**

1. A housing (7) for a semiconductor module (100) comprises:

a first plurality (n) of side elements (700n); and
a second plurality (m) of hinge portions (700i), wherein
n = m + 1,
in an unassembled state of the housing (7), the side elements (700n) are arranged successively in one row and each of the hinge portions (700i) is arranged to connect two directly neighboring side elements (700n),
each of the side elements (700n) is foldable with respect to at least one other side element (700n) about a respective folding axis (A1, A2, A3),
the side elements (700n) are configured to form a closed frame in an assembled state of the housing (7), wherein the side elements (700n) are configured to form sidewalls of the housing.

2. The housing (7) of claim 1, wherein each of the hinge portions (700i) is formed by means of a silicone rubber material.

3. The housing (7) of claim 1, wherein

each of the side elements (700n) has a first thickness ($d700_{max}$),
each of the hinge portions (700i) comprises a first end having the first thickness ($d700_{max}$) and connected to one of the side elements (700n), a second end having the first thickness ($d700_{max}$) and connected to another one of the side elements (700n), a first section, a second section, and a third section arranged successively between the first end and the second end, wherein the second section has a second thickness ($d700_{min}$) that is less than the first thickness ($d700_{max}$), wherein a thickness of the first section between the first end and the second section gradually decreases from the first thickness ($d700_{max}$) to the second thickness ($d700_{min}$), and wherein a thickness of the third section between the second section and the second end gradually increases from the second thickness ($d700_{min}$) to the first thickness ($d700_{max}$), and
the housing (7) is configured to form a closed frame in an assembled shape by bending the second sections of the connecting portions (700i) about a respective folding axis (A1, A2, A3) until the respective first and third sections are in direct contact with each other.

4. The housing (7) of any of claims 1 to 3, further comprising a lid (730) coupled to one of the plurality of side elements (700b), and foldable with respect to an additional folding axis.

5. The housing (7) of claim 4, wherein, in the assembled state of the housing (7), the closed frame formed by the first plurality (n) of side elements (700n) defines an inner volume, and the lid (730) covers the inner volume from one side.

6. The housing (7) of claim 4 or 5, wherein the lid (730) is coupled to the respective one of the plurality of side elements (700b) by means of a foldable element (736), wherein the foldable element (736) comprises a first section and a second section, wherein the first section is coupled to the respective side element (700b), the second section is coupled to the lid (730), the first section is bendable with respect to the side element (700b), the second section is bendable with respect to the lid (730), and the first and second sections are bendable with respect to each other.

7. The housing (7) of any of claims 4 to 6, wherein, in the assembled state of the housing (7), the lid (730) is attached to the closed frame formed by the side elements (700n) by means of one or more fastening elements (732, 734).

8. The housing (7) of any of the preceding claims, further comprising a sealing element (720), wherein the sealing element (720), in the assembled state of the housing (7), extends around the inner volume defined by the side elements (700n).

9. The housing (7) of claim 8, wherein the sealing element (720) further comprises a portion forming a continuous thread around the circumference of the lid (730) such that, in the assembled state of the housing (7), it is arranged between the lid (730) and the side elements (700n), thereby sealing the inner volume of the housing (7).

10. The housing (7) of any of the preceding claims, further comprising a fastening element (710, 712), wherein the fastening element (710, 712), in the assembled state of the housing (7), is configured to connect two outermost side elements (700n) in the row of side elements (700n) with each other such that the housing (7) remains in its assembled shape.

11. The housing (7) of claim 10, wherein the fastening element (710, 712) is a snap-fit connector or latching mechanism.

12. The housing (7) of any of the preceding claims, further comprising at least one foldable mounting element attached to a side element (700n), wherein the foldable mounting element comprises a through hole for mounting the housing (7) on a heat sink (82) by means of a screw (72).

13. The housing of any of the preceding claims, wherein n = 4 and m = 3.

14. A semiconductor module (100) comprises:

a housing (7) according to any of claims 1 to 13 in its assembled shape; and
a substrate (10), wherein

the housing (7) forms a closed frame around the substrate (10) and exerts pressure on each of a plurality of side surfaces of the substrate (10) along the circumference of the substrate (10).

15. A method for assembling a semiconductor module (100), the method comprising:
folding a housing (7) according to any of claims 1 to 13 around a substrate (10) by bending the plurality of side elements (700n) about respective bending axes (A1, A2, A3) until the side elements (700n) form a closed frame around the substrate (10) and exert pressure on each of a plurality of side surfaces of the substrate (10) along the circumference of the substrate (10).

FIG 1

FIG 2

FIG 3

FIG 4A

FIG 4B

FIG 4C

**FIG 5**

**FIG 6A**

**FIG 6B**

**FIG 6C**

700j  700a  700i  700b  720  700i  700c  700i  700d  712

710

700j

Z
X
**FIG 7A**

700j

710  700a

700b  720  700i  700c  700i  700d  712

A1

700j

Z
X
**FIG 7B**

700a  710
700j

700b  720

700c  700i  700d  712

A2

700j

Z
X
**FIG 7C**

700b

700a

700c  720

710

A3

712

700d  700j

Z
X
**FIG 7D**

FIG 8A

FIG 8B

FIG 8C

FIG 9A

FIG 9B

FIG 9C

**FIG 10A**

**FIG 10B**

**FIG 10C**

FIG 11A

FIG 11B

FIG 12

**FIG 13**

**FIG 14**

**FIG 15A**

**FIG 15B**

**EUROPEAN SEARCH REPORT**

Application Number

EP 24 16 2268

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KIMIONIS JOHN ET AL: "3D-Printed Origami Packaging With Inkjet-Printed Antennas for RF Harvesting Sensors", IEEE TRANSACTIONS ON MICROWAVE THEORY AND TECHNIQUES, IEEE, USA, vol. 63, no. 12, 1 December 2015 (2015-12-01), pages 4521-4532, XP011592637, ISSN: 0018-9480, DOI: 10.1109/TMTT.2015.2494580 [retrieved on 2015-12-02] | 1,2,4,5, 7,10,13 | INV. H01L21/50 H01L23/04 H01L23/10 |
| Y | * page 4521 - page 4523; figures | 3,11 | |
| A | 1,2,5,14,24 * | 6,8,9, 12,14,15 | |
| | - - - - - | | |
| Y | JP 2004 238014 A (MURAZUMI KK) 26 August 2004 (2004-08-26) | 3,11 | |
| A | * paragraph [0021] - paragraph [0024]; figures 2,4,7,8 * | 1,2, 4-10, 12-15 | |
| | - - - - - | | TECHNICAL FIELDS SEARCHED (IPC) |
| A | EP 3 249 684 B1 (DELTA ELECTRONICS INC [TW]) 30 December 2020 (2020-12-30) * the whole document * | 1-15 | H01L |
| | - - - - - | | |

The present search report has been drawn up for all claims

| Place of search | Date of completion of the search | Examiner |
|---|---|---|
| Munich | 29 July 2024 | Ardakanian, Niyousha |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 16 2268

This annex lists the patent family members relating to the patent documents cited in the above-mentioned European search report.
The members are as contained in the European Patent Office EDP file on
The European Patent Office is in no way liable for these particulars which are merely given for the purpose of information.

29-07-2024

| Patent document cited in search report | | Publication date | Patent family member(s) | | Publication date |
|---|---|---|---|---|---|
| JP 2004238014 | A | 26-08-2004 | NONE | | |
| EP 3249684 | B1 | 30-12-2020 | CN | 107424985 A | 01-12-2017 |
| | | | EP | 3249684 A1 | 29-11-2017 |
| | | | US | 2017339798 A1 | 23-11-2017 |